(19) Europäisches Patentamt
European Patent Office
Office européen des brevets

(11) Publication number: 0 070 734 B2

(12) # NEW EUROPEAN PATENT SPECIFICATION

(45) Date of publication of the new patent specification: **02.05.91 Bulletin 91/18**

(51) Int. Cl.$^5$: **H03M 1/36**

(21) Application number: **82303802.1**

(22) Date of filing: **20.07.82**

(54) **Analog-to-digital converters.**

(30) Priority: **21.07.81 JP 113901/81**
**16.11.81 JP 183510/81**

(43) Date of publication of application:
**26.01.83 Bulletin 83/04**

(45) Publication of the grant of the patent:
**14.10.87 Bulletin 87/42**

(45) Mention of the opposition decision:
**02.05.91 Bulletin 91/18**

(84) Designated Contracting States:
**AT DE FR GB NL**

(56) References cited:
**FR-A- 2 454 229**
**FR-A- 2 458 178**
**US-A- 3 446 989**
**US-A- 3 678 292**
**US-A- 3 812 478**
**US-A- 3 935 569**

(56) References cited:
**ELECTRONIC ENGINEERING, vol. 48, no. 585, November 1976, pages 28-29, London, GB. R. W. HARTLEY: "Special purpose analogue to digital converter"**
**IEEE Journal of Solid-State Circuits, Vol. SC-15, No. 6, Dec. 1980, pp.1030-1032**
**IEEE Journal of Solid-State Circuits, Vol. SC-14, No. 6, Dec. 1979, pp. 932-937**
**Horowitz, P. and Hill, W.: The Art of Electronics, Cambridge UP, 1980, pp. 82, 83, 331**

(73) Proprietor: **SONY CORPORATION**
**7-35 Kitashinagawa 6-Chome Shinagawa-ku**
**Tokyo 141 (JP)**

(72) Inventor: **Sekino, Takeo**
**3-1-3-402, Tobio**
**Atsugi-shi Kanagawa-ken (JP)**
Inventor: **Takeda, Masashi**
**1-37-3, Sakuradai Isehara-shi**
**Kanagawa-ken (JP)**

(74) Representative: **Thomas, Christopher Hugo et al**
**D Young & Co 10 Staple Inn**
**London WC1V 7RD (GB)**

EP 0 070 734 B2

Jouve, 18, rue Saint-Denis, 75001 PARIS

## Description

This invention relates to analog-to-digital converters.

Analog-to-digital (A/D) converters are known which are constructed as a parallel A/D converter as shown in Figure 1 of the accompanying drawings or as a serial-to-parallel A/D converter as shown in Figure 2 of the accompanying drawings.

The parallel A/D converter of Figure 1 is for 8-bit A/D conversion and comprises 255 voltage comparing circuits (comparators) $A_1$ to $A_{255}$ in which an analog input voltage $V_{in}$ is compared with each of 255-step reference voltage $V_1$ to $V_{255}$. The compared outputs therefrom are all supplied to an encoder ENC, from which 8-bit digital outputs $D_0$ to $D_7$ are derived.

On the other hand, in the serial-to-parallel A/D converter of Figure 2 which is also for use in 8-bit A/D conversion, the input voltage $V_{in}$ is supplied to a 4-bit parallel A/D converter $ENC_m$ at the first stage which derives 4-bit digital outputs $D_7$ to $D_4$ of the upper or more significant bits. The digital outputs $D_7$ to $D_4$ are supplied to a digital-to-analog (D/A) converter CONV, in which they are converted to an analog voltage $V_m$. A differential voltage $V_{in}$-$V_m$ between the input voltage $V_{in}$ and the analog voltage $V_m$ is supplied to a 4-bit parallel A/D converter at the next stage, from which 4-bit digital outputs $D_3$ to $D_0$ of the lower or less significant bits are derived.

The known parallel A/D converter of Figure 1 needs $(2^n - 1)$ voltage comparators to convert the analog input voltage $V_{in}$ to n-bit digital outputs, so that the number of circuit elements required is large. This leads to increased chip size and increase of power consumption when the A/D converter is formed as an integrated circuit (IC).

The known serial-to-parallel A/D converter of Figure 2 needs only $(2^m + 2^n - 2)$ voltage comparators to convert the analog input voltage $V_{in}$ to (m + n)-bit digital outputs, thus resulting in reduction of the chip size and the power consumption. However, the serial-to-parallel A/D converter of Figure 2 needs the D/A converter CONV and moreover, if there exists an error between the output of the upper bit converting A/D converter $ENC_m$ at the first stage and the output of the D/A converter CONV, then this error appears directly as a conversion error and hence an error will occur at the junction between the upper and lower bit outputs. In other words, when the analog input voltage $V_{in}$ increases, for example, linearly, the digital output dips at the point where the digital output is carried from the lower bits to the upper bits, and thereafter the digital output does not increase linearly.

An A/D converter of similar type to that shown in Figure 2 is described in "Electronic Engineering", Vol. 48, No. 585, pages 28 and 29.

Japanese patent specification JP-A-56-23026 discloses an m + n bit analog to digital (A/D) converter with the following features :

a voltage divider comprising $2^{m+n} - 1$ series resistors in groups ;

$2^m - 1$ voltage comparators for determining more significant bit data of m bits, and a more significant bit encoder encoding these bit data ;

$2^n - 1$ voltage comparators for determining less significant bit data of n bits, and a less significant bit encoder encoding these bit data ; and

$2^m(2^n - 1)$ switching elements, each associated with a respective series resistor to provide voltage comparison data to one of the less significant bit data determining comparators when not inhibited by a control signal derived (via a detection circuit) from outputs of the more significant bit data determining comparators, the switching elements forming groups each of which is associated with a respective one of the less significant bit data determining comparators.

According to the present invention there is provided an analog-to-digital converter for converting an analog input voltage to a digital output of m + n bits, the converter comprising :

a series resistor group ;

$2^m - 1$ voltage comparators for determining more significant bit data of m bits ;

a more significant bit encoder for encoding outputs from said more significant bit data determining voltage comparators ;

$2^n - 1$ voltage comparators for determining less significant bit data of n bits ; and

a less significant bit encoder for encoding outputs from said less significant bit data determining voltage comparators ;

said converter being formed as an integrated circuit on one integrated circuit chip ; said series resistor group comprising at least $2^{m+n} - 1$ resistors formed in a zig-zag pattern on said chip, and voltages to be compared in said more significant bit data determining voltage comparators being derived at turning points of said series resistor group ;

said voltage comparators each comprising bipolar transistors ;

$2^m(2^n - 1)$ comparator switching elements being provided, each said comparator switching element comprising a pair of differentially-connected bipolar transistors and a current switching bipolar transistor, and being associated with a respective resistor of said series resistor group to provide voltage comparison data to one of said less significant bit data determining voltage comparators when not inhibited by a control signal derived from outputs of said more significant bit data determining voltage comparators and supplied to the respective said current switching transistor, said comparator switching elements forming groups each of which is associated with a respective one of said less significant bit data determining voltage comparators ; and

said $2^{m-1}$ more significant bit data determining voltage comparators being divided into two groups located on respective sides of said switching element groups.

The invention will now be described by way of example with reference to the accompanying drawings throughout which like references designate like elements, and in which :

Figure 1 is a block diagram of one example of a known parallel A/D converter ;

Figure 2 is a block diagram of one example of a known serial-to-parallel A/D converter ;

Figures 3A and 3B are circuit diagrams which together show an embodiment of A/D converter according to the invention ;

Figures 4A and 4B are truth tables used to explain the embodiment ;

Figures 5A and 5B are circuit diagrams showing preferred circuit arrangements when an embodiment of the invention is formed on an IC chip ;

Figures 6 and 7 are circuit block diagrams showing arrangements of elements and circuits of an embodiment of the invention when it is formed on an IC chip ; and

Figures 8 and 9 are comparison block diagrams used to explain the advantages of embodiments of the invention.

Referring first to Figure 3, an embodiment of A/D converter according to the invention for converting an analog input voltage $V_{in}$ to 4-bit digital outputs $D_3$ to $D_0$ will be described.

The A/D converter comprises three upper-bit voltage comparators (hereinafter simply referred to as coarse comparators) $M_3$ to $M_1$ and three lower-bit voltage comparators (hereinafter simply referred to as fine comparators) $N_3$ to $N_1$. In each of the coarse comparators $M_3$ to $M_1$ emitters of transistors $Q_{m1}$ and $Q_{m2}$ are connected together to a constant current source $S_m$, and in each of the fine comparators $N_3$ to $N_1$ the emitters of transistors $Q_{n1}$ and $Q_{n2}$ are connected together to a constant current source $S_n$.

Voltage comparators $A_{ij}$ (where i is in the range 4 to 1 and j is in the range from 3 to 1) are provided as matrixes. Each of the voltage comparators $A_{ij}$ is constructed such that emitters of transistors $Q_1$ and $Q_2$ are connected together to the collector of a current switching transistor $Q_3$. The voltage comparators $A_{i3}$ to $A_{i1}$ operate primarily as the first-stage comparators of the fine comparators $N_3$ to $N_1$.

Sixteen resistors $R_0$ to $R_{15}$, each having an equivalent resistance value, are connected in series as a resistor string between a reference voltage source $V_r$ and ground so as to form 16-step reference voltages $V_{15}$ to $V_0$. Of these 16-step reference voltages $V_{15}$ to $V_0$, the voltages $V_{12}$, $V_8$ and $V_4$ of every fourth step are respectively supplied to the bases of the transistors $Q_{m1}$ in the coarse comparators $M_3$ to $M_1$, and the voltages $V_{15}$ to $V_{13}$ and $V_7$ to $V_5$ are respectively supplied to the bases of the transistors $Q_2$ in the coarse comparators $A_{4j}$ and $A_{2j}$. The remaining voltages $V_9$ to $V_{11}$ and $V_1$ to $V_3$ are respectively supplied to the bases of the transistors $Q_1$ of the voltage comparators $A_{3j}$ to $A_{1h}$. Moreover, to the bases of the transistors $Q_2$ of the coarse comparators $M_3$ to $M_1$ and to the bases of the transistors $Q_1$ and $Q_2$ of the voltage comparators $A_{ij}$, which are not yetsupplied with the voltages $V_{15}$ to $V_1$, is supplied the analog input voltage $V_{in}$.

A collector output $P_3$ of the transistor $Q_{m1}$ of the coarse comparator $M_3$ is supplied to the bases of the transistors $Q_3$ of the voltage comparator $A_{4j}$. A wired-AND output $P_2$ between the outputs at the collectors of the transistors $Q_{m2}$ of the coarse comparator $M_3$ and the transistor $Q_{m1}$ of the coarse comparator $M_2$ is supplied to the bases of the transistors $Q_3$ of the comparators $A_{3j}$. A wired-AND output $P_1$ between the outputs at the collectors of the transistor $Q_{m2}$ of the coarse comparator $M_2$ and the transistor $Q_{m1}$ of the coarse comparator $M_1$ is supplied to the bases of the transistors $Q_3$ of the comparators $A_{2j}$, a collector output $P_0$ of the transistor $Q_{m2}$ of the coarse comparator $M_1$ is supplied to the bases of the transistors $Q_3$ of the comparators $A_{1j}$. The emitters of the transistors $Q_3$ of the comparators $A_{i3}$ to $A_{i1}$ are connected to respective constant current sources $S_3$, $S_2$ and $S_1$. Also, the outputs $P_3$ to $P_1$ of the coarse comparators $M_3$ to $M_1$ are supplied to an upper-bit (coarse) encoder ENCM which derives the upper two bits $D_3$ and $D_2$ of the digital outputs. The coarse 2-bit encoder ENCM supplies a control signal to a two lower-bit (fine) encoder ENCN if necessary. Thus, in the embodiment, a resistor string is provided on the IC chip in zigzag line, so that lower bit data must be inverted in response to the value of the input voltage relative to the compared output. For instance, with respect to input voltage values denoted by points ① and ②, which will be discussed later, it is necessary to invert the lower bit data. To this end, based upon the least significant bit data of the 2-bit coarse encoder ENCM, the output data of the 2-bit fine encoder ENCN must be inverted.

The collectors of the transistors $Q_1$ and $Q_2$ of the comparators $A_{i3}$ to $A_{j1}$ are respectively connected to the bases of the transistors $Q_{n1}$ and $Q_{n2}$ of the fine comparators $N_3$ to $N_1$. A collector output $B_3$ of the transistor $Q_{n1}$ of the fine comparator $N_3$, a wired-AND output $B_2$ between the outputs of the collectors of the transistor $Q_{n2}$ of the fine comparator $N_3$ and the transistor $Q_{n1}$ of the fine comparator $N_2$ and a wired-AND output $B_1$ between the outputs at the collectors of the transistor $Q_2$ of the comparator $N_2$ and the transistor $Q_{n1}$ of the comparator $N_1$ are all supplied to the 2-bit fine encoder ENCN and the bit $D_2$ is supplied from the 2-bit coarse encoder ENCM thereto, so that the 2-bit fine encoder ENCN produces the lower two bits $D_1$ and $D_0$ of the digital output. An example of each of the truth tables of the coarse and fine encoders ENCM and ENCN is shown in Figures 4A and 4B.

With the arrangement thus formed, as, for example, shown by a point ① in Figure 3, let us assume that the analog input voltage $V_{in}$ is less than the reference voltage $V_7$ and greater than the reference voltage $V_6$. Hereinafter, corresponding to the above point ①, characters "H" and "L", both showing the level of the signal are suffixed with 1 as in "$H_1$" and "$L_1$".

Then, since the analog input voltage $V_{in}$ is less than the reference voltage $V_8$ and less than the reference voltage $V_{12}$, the bases of the transistors $Q_{m1}$ of the coarse comparators $M_3$ and $M_2$ become "$H_1$" and the bases of the transistors $Q_{m2}$ thereof become "$L_1$", so that the collectors of the transistors $Q_{m1}$ become "$H_1$". Also, since the analog input voltage $V_{in}$ is greater than the reference voltage $V_4$, the base of the transistor $Q_{m1}$ of the coarse comparator $M_1$ becomes "$L_1$" and the base of the transistor $Q_{m2}$ becomes "$H_1$" so that the collector of its transistor $Q_{m1}$ becomes "$H_1$" and the collector of its transistor $Q_{m2}$ becomes "$L_1$". Accordingly, since the collector output $P_3$ is equal to "$L_1$", the collector output $P_2$ is equal to "$L_1$", the collector output $P_1$ is equal to "$H_1$", and the collector output $P_0$ is equal to "$L_1$", from the truth table of Figure 4A, the bit $D_3$ is equal to "0" and the bit $D_2$ is equal to "1" and in this case, the output $P_2$ becomes "$L_1$" as a result of AND logics of "$L_1$" and "$H_1$".

Whereas, since the collector output $P_3$ is equal to "$L_1$", the collector output $P_2$ is equal to "$L_1$", the collector output $P_1$ is equal to "$H_1$" and the collector output $P_0$ is equal to "$L_1$", only the transistors $Q_3$ of the comparator $A_{2j}$ are made ON, so that the analog input voltage $V_{in}$ is compared with the reference voltages $V_7$ to $V_5$ in the comparator $A_{2j}$. Since the analog input voltage $V_{in}$ is less than the reference voltage $V_7$ and is greater than the reference voltage $V_6$, the base of the transistor $Q_1$ of the comparator $A_{23}$ becomes "$L_1$" and the base of its transistor $Q_2$ becomes "$H_1$" so that the collector of its transistor $Q_1$ becomes "$H_1$" and the collector of its transistor $Q_2$ becomes "$L_1$". Likewise, while the bases of the transistors $Q_1$ of the comparators $A_{22}$ and $A_{21}$ become "$H_1$" and the bases of the transistor $Q_2$ become "$L_1$", the collectors of the transistors $Q_1$ become "$L_1$" and the collectors of the transistors $Q_2$ become "$H_1$".

These outputs are supplied to the fine comparators $N_3$ to $N_1$, by which the collector of the transistor $Q_{n1}$ to the fine comparator $N_3$ becomes "$L_1$" and the collector of the transistor $Q_{n2}$ thereof becomes "$H_1$", while the collectors of the transistors $Q_{n1}$ of the fine comparators $N_2$ and $N_1$ both become "$H_1$" and the collectors of the transistors $Q_{n2}$ become "$L_1$". Accordingly the collector output $B_3$ is equal to "$L_1$", the collector output $B_2$ is equal to "$H_1$" and the collector output $B_1$ is equal to "$L_1$" and, at the same time, the bit $D_2$ is equal to "1". Therefore, from the truth table of Figure 4B, the bit $D_1$ is equal to "1" and the bit $D_0$ is equal to "0".

Therefore, when the analog input voltage $V_{in}$ is less than the reference voltage $V_7$ and is greater than the reference voltage $V_6$ as shown by the point 1, the digital outputs $D_3$ to $D_0$ thus obtained are represented by "0 1 1 0". When the instantaneous analog input voltage $V_{in}$ is quantized with fractions omitted, it has the level of 6th step counting from the grounded side (the grounded electric potential is taken as the 0th step). Thus since six is representative of "0 1 1 0", the digital outputs $D_3$ to $D_0$ equal to "0 1 1 0" are the correct digital outputs.

While as, for example, shown by a point ② in Figure 3A, let us assume that the analog input voltage $V_{in}$ is less than the reference voltage $V_{10}$ and is greater than the reference voltage $V_9$. Hereinafter, characters "H" and "L" indicating the level of the signal are suffixed by "2" in respect of the point ②.

Then, since the analog input voltage $V_{in}$ is less than the reference voltage $V_{12}$, the base of the transistor $Q_{m1}$ of the coarse comparator $M_3$ becomes "$H_2$" and the base of the transistor $Q_{m2}$ becomes "$L_2$" so that the collector of the transistor $Q_{m1}$ becomes "$L_2$" and the collector of transistor $Q_{m2}$ becomes "$H_2$". In addition, since the analog input voltage $V_{in}$ is greater than the reference voltage $V_8$ and is also greater than the reference voltage $V_4$, the bases of the transistors $Q_{m1}$ of the comparators $M_2$ and $M_1$ becomes "$L_2$" and the bases of the transistors $Q_{m2}$ thereof becomes "$H_2$", so that the collectors of the transistor $Q_{m1}$ becomes "$H_2$" and the collectors of the transistors $Q_{m2}$ become "$L_2$". Therefore, since the collector output $P_3$ is equal to "$L_2$", the collector output $P_2$ is equal to "$H_2$", the collector output $P_1$ is equal to "$L_2$" and the collector output $P_0$ is equal to "$L_2$", from the truth table of Figure 4A, the digital output $D_3$ is equal to "1" and the digital output $D_2$ is equal to "0".

While, since the collector output $P_3$ is equal to "$L_2$", the collector output $P_2$ is equal to "$H_2$", the collector output $P_1$" is equal to "$L_2$" and the collector output $P_0$ is equal to "$L_2$", only the transistors $Q_3$ of the comparator $A_{3j}$ are made ON so that the input voltage $V_{in}$ is compared with reference voltages $V_9$ to $V_{11}$ in the comparator $A_{3j}$. Since the input voltage $V_{in}$ is greater than the reference voltage $V_9$ and is less than the reference voltage $V_{10}$, the base of the transistor $Q_1$ of the comparator $A_{33}$ becomes "$L_2$" and the base of the transistor $Q_2$ thereof becomes "$H_2$" so that the collector of the transistor $Q_1$ becomes "$H_2$" and the collector of the transistor $Q_2$ becomes "$L_2$". Thus, at the same time, the bases of the transistors $Q_1$ of the comparators $A_{32}$ and $A_{31}$ become both "$H_2$" and the bases of the transistors $Q_2$ thereof become both "$L_2$", so that the collectors of the transistors $Q_1$ become "$L_2$" and the collectors of the transistors $Q_2$ become "$H_2$".

Since these outputs are supplied to the fine comparators $N_3$ to $N_1$, while the collector of the transistor

$Q_{n1}$ of the fine comparator $N_3$ becomes "$L_2$" and the collector of the transistor $Q_{n2}$ thereof becomes "$H_2$", the collectors of the transistors $Q_{n1}$ of the fine comparators $N_2$ and $N_1$ become "$H_2$" and the collectors of the transistors $Q_{n2}$ thereof become "$L_2$". Therefore, since the output $B_3$ is equal to "$L_2$", the output $B_2$ is equal to "$H_2$" and the output $B_1$ is equal to "$L_2$", and also the digital output $D_2$ is equal to "0", from the truth table of Figure 4B, the digital output $D_1$ is equal to "0" and the digital output $D_0$ is equal to "1".

Accordingly, when the analog input voltage $V_{in}$ is less than the reference voltage $V_{10}$ and is greater than the reference voltage $V_9$ as shown by the point 2, the digital outputs $D_3$ to $D_0$ becomes "1 0 0 1". If the input voltage $V_{in}$ is quantized with fractions omitted, it has the level of 9th step counting from the grounded side. As nine is equal to "1 0 0 1", the digital outputs $D_3$ to $D_0$ are the correct digital outputs.

As described above, with the described embodiment of A/D converter, the reference voltages $V_{15}$ to $V_0$ are divided into four groups of $V_{15}$ to $V_{12}$ ; $V_{11}$ to $V_8$; $V_7$ to $V_4$ ; and $V_3$ to $V_0$, in which the voltages $V_{12}$, $V_8$, $V_4$ (and $V_{01}$) each being representative of the respective four groups are compared with the analog input voltage $V_{in}$ so as to derive the upper 2 bits $D_3$ and $D_2$ of the digital output. In response to the upper two bits $D_3$ and $D_3$, voltage groups $V_k$ to $V_{k-3}$ (where k is equal to 15, 11 and 7) are selected, and then the voltages $V_k$ to $V_{k-3}$ of the selected group are compared with the input voltage $V_{in}$ so as to develop the lower two bits $D_1$ and $D_0$ of the digital output.

Therefore, in the embodiment a reduction in the number of comparators is possible. In other words, let us assume there are m upper bits and n lower bits of the digital output. Then, the number of coarse comparators is $(2^m - 1)$ and the number of fine comparators is $(2^n - 1)$. Moreover, since the voltage comparators $A_{ij}$ are initially the indispensable first-stage circuits for the fine comparators $N_1$ to $N_3$ and the voltage comparators $A_{ij}$ can serve as the first stage circuits and the switching circuits, this leads to a reduction in the number of the transistors required. Thus it is possible to reduce both the semiconductor chip size and the power consumption when the A/D converter is formed as an IC.

Moreover, the reference voltages $V_{15}$ to $V_0$ are used in common for deriving the upper bits $D_3$ and $D_2$ and the lower bits $D_1$ and $D_0$, so the linearity between the analog input voltage $V_{in}$ and the digital outputs $D_3$ to $D_0$ is perfect.

Since the voltage comparators are all formed of bipolar transistors, the maximum driving frequency can be selected to be high, so that A/D conversion of, for example, a video signal at the required high speed is possible.

It might be considered that the above voltage switching comparators could be replaced by switching circuits employing voltage control elements such as metal oxide semiconductorfield effect transistors (MOS-FETs). In this case, however, because a MOS-FET is slow in switching operation, increase in the accuracy of the comparator cannot be expected. Thus the employment of bipolar transistors as the voltage control elements is preferred. In addition, the switching circuits comprise pairs of differential transistors so that there is little error due to temperature drift.

Figure 5 illustrates an example of a preferred circuit arrangement of the A/D converter when it is formed on an IC chip. The upper-bit data determining or coarse comparators $M_1$ to $M_3$ are distributed into right and left parts of the comparator $A_{3j}$ to allow parasitic capacitances between the signal lines to be decreased and the space factor of the IC chip to be improved. The others are the same as those of Figure 3.

Next, the pattern of an embodiment of A/D converter according to the invention which is formed as an IC will be described with reference to Figure 6 and the following drawings, where the analog input voltage is divided into four upper and four lower bits so as to carry out 8-bit A/D conversion. Accordingly, the number of resistors R is selected as 256 ($2^8$) designated $R_0$ to $R_{255}$, and the number of steps of the reference voltage V is 256 from $V_0$ to $V_{255}$. The number of coarse and fine comparators M and N are respectively as 15 ($2^4 - 1$) designated $M_1$ to $M_{15}$ and $N_1$ to $N_{15}$. The number of voltage comparators $A_{ij}$ to compare the input voltage $V_{in}$ with the reference voltages $V_1$ to $V_{255}$ is 16 × 15 designated $A_{0101}$ to $A_{1615}$ (where i = 1 to 16 and j = 1 to 15).

Figure 6 shows an arrangement of elements and circuits and the positional relation therebetween on a semiconductor chip when an embodiment of 8-bit A/D converter according to the invention is formed as an IC. SP designates the semiconductor pellet whose dimension is, for example, 3.95 mm by 5.93 mm. On the surface of the semiconductor pellet SP is formed a resistor layer RL of uniform width made, for example, of an evaporated aluminium film formed in predetermined lengths as a zig-zag line. It is arranged that two of the adjacent straight line portions of the resistor layer RL form one group, the two straight line portions of each group being close to one another but there being a substantial distance between adjacent groups.

This resistor layer RL forms the series connection of the resistors $R_0$ to $R_{255}$. More particularly, in the resistor layer RL, the respective points at each predetermined length correspond to the respective connection points of the resistors $R_0$ to $R_{255}$, and the respective reference voltages $V_0$ to $V_{255}$ are developed at the respective points mentioned above. The respective straight line portion of the resistor layer RL corresponds to $2^4$ resistors of the resistors $R_0$ to $R_{255}$, so that the turning points of the resistor layer RL correspond to the turning points of the series circuit formed of the resistors $R_0$ to $R_{15}$ in Figure 1. These turning points are the points at which the reference voltages $V_{16}$, $V_{32}$,... $V_{224}$, $V_{240}$ of every $2^4$ steps are developed.

The reason why the resistor layer RL is centred and formed as the regular pattern as described above is that the conversion accuracy of this A/D converter is determined by the accuracy of each of the reference voltages $V_0$ to $V_{255}$, and the accuracy of each of the reference voltages $V_0$ to $V_{255}$ is determined by the accuracy of each of the resistors $R_0$ to $R_{255}$.

For the resistor layer RL, voltage comparators $A_{ij}$ corresponding to its straight line portions are formed 15 by 15 adjacent to the straight line portions. In this case, since the straight line portions of the resistor layer RL are formed as each one group of the two, and the adjacent groups are spaced apart from one group to another, the voltage comparators other than the first and last voltage comparators $A_{1j}$ and $A_{16j}$ are arrayed in every two rows within the portions between the spaced straight line portions of the resistor layer RL.

Moreover, at the ends of the respective turning points of the resistor layer RL are formed the coarse comparators $M_1$ to $M_{15}$ at every other one, and the coarse comparators $M_1$ to $M_{15}$ provided at every other one are adjacent to each other. At the outside and adjacent regions of the voltage comparators $A_{16j}$ are formed the fine comparators $N_1$ to $N_{15}$, each being provided in a row and being adjacent to one another in the direction to which the voltage comparators $A_{16j}$ are arranged.

Furthermore, while on the outside regions of the fine comparators $N_1$ to $N_{15}$ is formed the fine encoder ENCN, on the outside regions of the every other coarse comparators $M_1$ to $M_{15}$ is formed the coarse encoder ENCM. Also, with respect to the resistor layer RL, at the regions opposite to the fine comparators $N_1$ to $N_{15}$ are formed constant current sources $Q_{001}$ to $Q_{015}$. In addition, at the outside regions of the constant current sources $Q_{001}$ to $Q_{015}$ and the outside regions of the coarse and fine encoders ENCM and ENCN are formed bonding pads (not shown) connected with bonding wires, if necessary, by way of upper and lower-bit output buffer circuits $B_M$ and $B_N$. Reference $P\phi$ identifies a clock generator. The upper and lower bit data $D_1$ to $D_8$ are respectively derived from the buffers $B_N$ and $B_M$.

Figure 7 shows the connection relation (Figures 5A and 5B) as well as the arrangement relation (Figure 6) of the main parts of the A/D converter together. However, this diagram of Figure 7 is the same as the case (the same as Figure 6) where the A/D converter is an 8-bit A/D converter, and shows part only of the relations between the voltage comparator $A_{ij}$, the coarse comparators $M_1$ to $M_{15}$ and the coarse encoder ENCM. Small block circles in the voltage comparators $A_{ij}$ correspond to the bases of the transistors $Q_3$ to which the outputs of the coarse comparators $M_1$ to $M_{15}$ are supplied.

As will be clear from Figure 7, the resistor layer RL is formed thereon in zig-zag pattern, the coarse comparators $M_1$ to $M_{15}$ are formed thereon at respective turning points of the resistor layer RL and the coarse encoder ENCM is formed at the outside.

With this embodiment of the invention the resistor layer RL and the coarse comparators $M_1$ to $M_{15}$ are provided as shown in Figures 6 and 7, so that the size of the semiconductor pellet SP can be further reduced.

In practice, since the coarse comparators $M_1$ to $M_{15}$ are constructed the same as the voltage comparators in the known A/D converters, for example, of Figures 1 and 2 such that the pure voltage comparator is connected with a waveform shaping circuit such as a Schmitt circuit or the like, the coarse comparators $M_1$ to $M_{15}$ used greater areas in the semiconductor pellet SP than other elements, for example, about nine times the areas of the voltage comparators $A_{ij}$.

Therefore, as shown in Figure 8 (which corresponds to Figure 7) ; when the coarse comparators $M_1$ to $M_{15}$ are arrayed in a row relative to the semiconductor pellet SP, no matter how close the coarse comparators $M_1$ to $M_{15}$ are to each other, the resistor layer RL and the voltage comparators $A_{ij}$ have gaps therearound thus resulting in increase of the size of the semiconductor pellet SP.

However, since as shown in Figures 6 and 7 the coarse comparators $M_1$ to $M_{15}$ are formed at each of the turning points of the resistor layer RL, no gaps will occur around the resistor layer RL and the voltage comparators $A_{ij}$, so the size of the semiconductor pellet SP can be reduced.

Moreover, the encoders ENCM and ENCN can be arranged and formed as shown in Figures 6 and 7. This also leads to further reduction in the size of the semiconductor pellet SP. By way of example, the size of the semiconductor pellet SP of Figure 6 can be about 5.4 mm (width) × 4.0 mm (length).

If the coarse comparators $M_1$ to $M_{15}$ are provided at each turning point of the resistor layer RL, that is, at the sides of the resistor layer RL, no problems will arise from parasitic capacitance. In other words, when the coarse comparators $M_1$ to $M_{15}$ are provided merely on both sides of the resistor layer RL, the circuitry thereof becomes as shown in Figure 9 (which corresponds to Figure 7). This indicates that the signal line to supply the outputs of the coarse comparators $M_2$, $M_4$,... $M_{14}$ opposing the coarse encoder ENCM are required, thus resulting in problems due to parasitic capacitance.

However, with embodiments of the invention, the wired-AND is carried out between a collector of the transistor $Q_1$ in a voltage comparator $M_k$ (where k = 1 to 14) and a collector of the transistor $Q_2$ in the next voltage comparator $M_{k+1}$, and its AND output is then supplied to the coarse encoder ENCM and the transistor $Q_3$ of the voltage comparator $A_{ij}$. Thus, even if the coarse comparators $M_1$ to $M_{15}$ are formed on both sides of the resistor layer RL, problems due to parasitic capacitance will not occur, to any significant extent.

Thus the embodiment of the invention can form A/D converters with small power consumption and high speed. In addition, the semiconductor pellet size of the IC chip can be reduced.

## Claims

1. An analog-to-digital converter for converting an analog input voltage to a digital output of m + n bits, the converter comprising :

a series resistor group ($R_0$, etc.) ;

$2^m - 1$ voltage comparators ($M_1$, etc.) for determining more significant bit data of m bits ;

a more significant bit encoder (ENCM) for encoding outputs from said more significant bit data determining voltage comparators ($M_1$, etc.) ;

$2^n - 1$ voltage comparators ($N_1$, etc.) for determining less significant bit data of n bits ; and

a less significant bit encoder (ENCN) for encoding outputs from said less significant bit data determining voltage comparators ($N_1$, etc.) ;

said converter being formed as an integrated circuit on one integrated circuit chip (SP) ;

said series resistor group ($R_0$, etc.) comprising at least $2^{m+n} - 1$ resistors ($R_0$, etc.) formed in a zigzag pattern on said chip (SP), and voltages to be compared in said more significant bit data determining voltage comparators ($M_1$, etc.) being derived at turning points of said series resistor group ($R_0$, etc.) ;

said voltage comparators ($M_1$, etc., $N_1$, etc.) each comprising bipolar transistors ($Q_{m1}$, etc., $Q_{n1}$, etc.) ;

$2^m(2^n - 1)$ comparator switching elements ($A_{ij}$) being provided, each said comparator switching element ($A_{ij}$) comprising a pair of differentially-connected bipolar transistors ($Q_1$, $Q_2$) and a current switching bipolar transistor ($Q_3$), and being associated with a respective resistor of said series resistor group ($R_0$, etc.) to provide voltage comparison data to one of said less significant bit data determining voltage comparators ($N_1$, etc.) when not inhibited by a control signal derived from outputs of said more significant bit data determining voltage comparators ($M_1$, etc.) and supplied to the respective said current switching transistor ($Q_3$), said comparator switching elements ($A_{ij}$) forming groups each of which is associated with a respective one of said less significant bit data determining voltage comparators ($N_1$, etc.) ; and

said $2^{m-1}$ more significant bit data determining voltage comparators ($M_1$, etc.) being divided into two groups located on respective sides of said switching element groups ($A_{ij}$ on said chip (SP)).

2. An analog-to-digital converter according to claim 1 wherein the number of said more significant bit data determining voltage comparators ($M_1$, etc.) is the same as that of said less significant bit data determining voltage comparators ($N_1$, etc.)

## Ansprüche

1. Analog-Digital-Wandler zur Umwandlung einer analogen Eingangsspannung in ein digitales Ausgangssignal mit m + n Bits

mit einer Gruppe von in Reihe geschalteten Widerständen ($R_0$, usw.),

mit $2^m - 1$ Spannungskomparatoren ($M_1$, usw.) zur Bestimmung der Daten von m höherwertigen Bits,

mit einem Kodierer (ENCM) für die höherwertigen Bits zur Kodierung der Ausgangssignale der Spannungskomparatoren ($M_1$, usw.) zur Bestimmung der Daten der höherwertigen Bits,

mit $2^n - 1$ Spannungskomparatoren ($N_1$, usw.) zur Bestimmung Daten von niedrigerwertigen Bits,

sowie mit einem Kodierer (ENCN) für die niedrigerwertigen Bits zur Kodierung der Ausgangssignale der Spannungskomparatoren ($N_1$, usw.) zur Bestimmung der Daten der niedrigerwertigen Bits, wobei

der Wandler als integrierte Schaltung auf einem einzigen integrierten Schaltungschip (SP) ausgebildet ist,

die Gruppe von in Reihe geschalteten Widerständen ($R_0$, usw.) wenigstens $2^{m+n} - 1$ Widerstände ($R_0$, usw.) umfaßt, die in einem Zickzackmuster auf dem Chip angeordnet sind,

die Spannungen, die in den Spannungskomparatoren ($M_1$, usw.) zur Bestimmung der Daten der höherwertigen Bits zu vergleichen sind, an den Umkehrpunkten der Gruppe von in Reihe geschalteten Widerständen ($R_0$, usw.) abgenommen werden,

die Spannungskomparatoren ($M_1$, usw., $N_1$, usw.) jeweils aus bipolaren Transistoren ($Q_{m1}$, usw., $Q_{n1}$, usw.) bestehen,

$2^m(2^n - 1)$ Komparatorschaltelemente ($A_{ij}$) vorgesehen sind, die jeweils ein Paar von in Differenzschaltung angeordneten bipolaren Transistoren ($Q_1$, $Q_2$, $Q_3$) und einen bipolaren Strom-Schalttransistor ($Q_3$) enthalten und die jeweils mit einem entsprechenden Widerstand aus der Gruppe von in Reihe geschalteten Widerständen ($R_0$, usw.) verbunden sind, um Spannungsvergleichswerte an einen der Spannungskomparatoren ($N_1$, usw.)

zur Bestimmung der Daten der niedrigerwertigen Bits zu liefern, falls er nicht durch ein aus den Ausgangssignalen der Spannungskomparatoren ($M_1$, usw.) zur Bestimmung der Daten der höhewertigen Bits abgeleitetes Steuersignal gesperrt ist, wobei diese Komparatorschaltelemente ($A_{ij}$) Gruppen bilden, die jeweils einem der Spannungskomparatoren ($N_1$, usw.) zur Bestimmung der Daten der niedrigerwertigen Bits zugeordnet sind,
und die $2^m - 1$ Spannungskomparatoren ($M_1$, usw.) zur Bestimmung der Daten der höherwertigen Bits in zwei Gruppen unterteilt sind, die an entsprechenden Seiten der Gruppen von Komparatorschaltelementen ($A_{ij}$ auf den Chip SP)) angeordnet sind.

2. Analog-Digital-Wandler nach Anspruch 1, bei dem die Zahl der Spannungskomparatoren ($M_1$, usw.) zur Bestimmung der Daten der höherwertigen Bits ebenso groß ist wie die Zahl der Spannungskomparatoren ($N_1$, usw.) zur Bestimmung der Daten der niedrigerwertigen Bits.

**Revendications**

1. Convertisseur analogique-numérique destiné à convertir une tension analogique d'entrée en une sortie numérique de m + n bits, le convertisseur comportant : un groupe de résistances en série ($R_0$, etc) ; $2^m - 1$ comparateurs de tension ($M_1$, etc.) destinés à déterminer les données binaires les plus significatives de m bits ; un codeur de bits les plus significatifs (ENCM) destiné à coder les sorties desdits comparateurs de tension ($M_1$, etc.) de détermination des données binaires les plus significatives ; $2^n - 1$ comparateurs de tension ($N_1$, etc.) destinés à déterminer les données binaires les moins significatives de n bits ; et un codeur debits les moins significatifs (ENCN) destiné à coder des sorties desdits comparateurs de tension ($N_1$, etc.) de détermination des données binaires les moins significatives ; le convertisseur étant formé en un circuit intégré sur une pastille de circuit intégré (SP) ; ledit groupe de résistances en série comportant au moins $2^{m+n} - 1$ résistances ($R_0$, etc.) formées en une configuration en zigzag sur ladite pastille, et les tensions à comparer dans lesdits comparateurs de tension ($M_1$, etc.) de détermination des données binaires les plus significatives étant obtenues aux points de rotation dudit groupe de résistances en série ($R_0$ etc.) ; lesdits comparateurs de tension ($M_1$, etc., $N_1$, etc.) consistant chacun en des transistors bipolaires ($Q_{m1}$, etc. $Q_{n1}$, etc.) ; $2^m(2^n - 1)$ éléments de commutation de comparateurs ($A_{ij}$) étant prévus, chacun desdits éléments de commutation de comparateur ($A_{ij}$) consistant en une paire de transistors bipolaires connectés en montage différentiels ($Q_1$, $QS_2$) et un transistor bipolaire de commutation de courant ($Q_3$) et étant associé avec une résistance respective dudit groupe de résistances en série ($R_0$, etc.) pour produire des données de comparaison de tension à destination de l'un desdits comparateurs de tension ($N_1$, etc.) de détermination des données binaires les moins significatives lorsqu'il n'est pas inhibé par un signal de commande provenant des sorties desdits comparateurs de tension ($M_1$, etc.) de détermination des données binaires les plus significatives et fourni audit transistor de commutation de courant ($Q_3$) respectif, lesdits éléments de commutation de comparateurs ($A_{ij}$) formant des groupes dont chacun est associé avec l'un respectif desdits comparateurs de tension ($N_1$, etc.) de détermination des données binaires les moins significatives ; et lesdits $2^m - 1$ comparateurs de tension ($M_1$, etc.) de détermination des données binaires les plus significatives étant divisés en deux groupes situés sur les côtés respectifs desdits groupes d'éléments de commutation ($A_{ij}$) sur ladite pastille (SP).

2. Convertisseur analogique-numérique selon la revendication 1, dans lequel le nombre desdits comparateurs de tension ($M_1$, etc.) de détermination des données binaires les plus significatives est le même que celui desdits comparateurs de tension ($N_1$, etc.) de détermination des données binaires les moins significatives.

F I G. 1
(PRIOR ART)

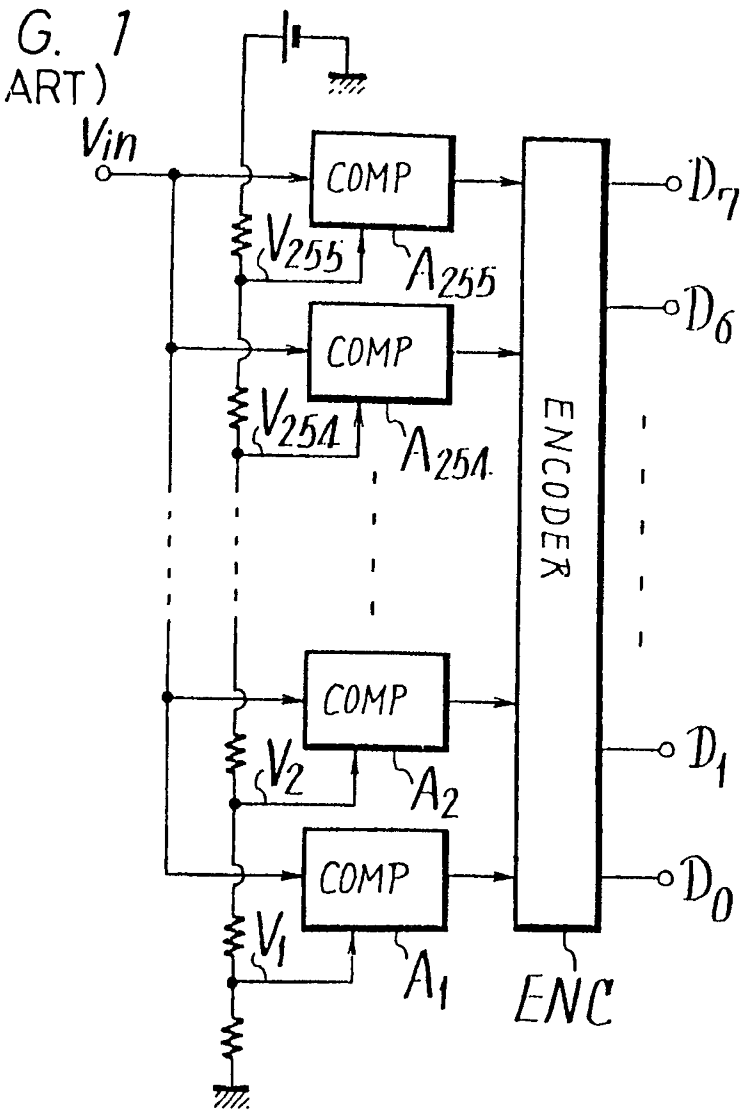


F I G. 4A

| | $P_3$ | $P_2$ | $P_1$ | $P_0$ | $D_3$ | $D_2$ |
|---|---|---|---|---|---|---|
| | L | L | L | H | 0 | 0 |
| ① | L | L | H | L | 0 | 1 |
| ② | L | H | L | L | 1 | 0 |
| | H | L | L | L | 1 | 1 |

F I G. 4B

| | $D_2$ | $B_3$ | $B_2$ | $B_1$ | $D_1$ | $D_0$ |
|---|---|---|---|---|---|---|
| | 0 | H | L | L | 0 | 0 |
| ② | 0 | L | H | L | 0 | 1 |
| | 0 | L | L | H | 1 | 0 |
| | 0 | L | L | L | 1 | 1 |
| | 1 | L | L | L | 0 | 0 |
| | 1 | L | L | H | 0 | 1 |
| ① | 1 | L | H | L | 1 | 0 |
| | 1 | H | L | L | 1 | 1 |

FIG. 2 (PRIOR ART)

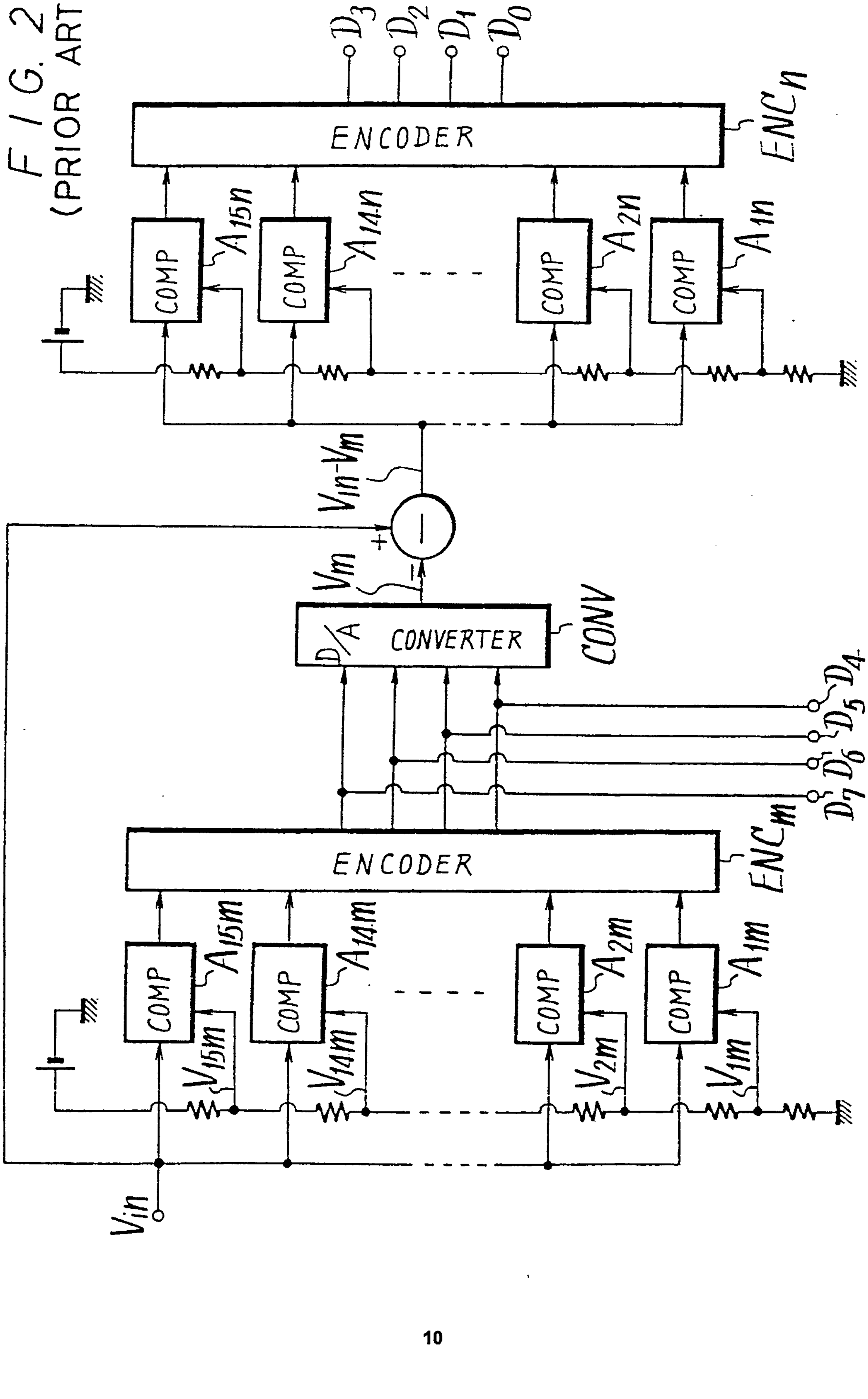

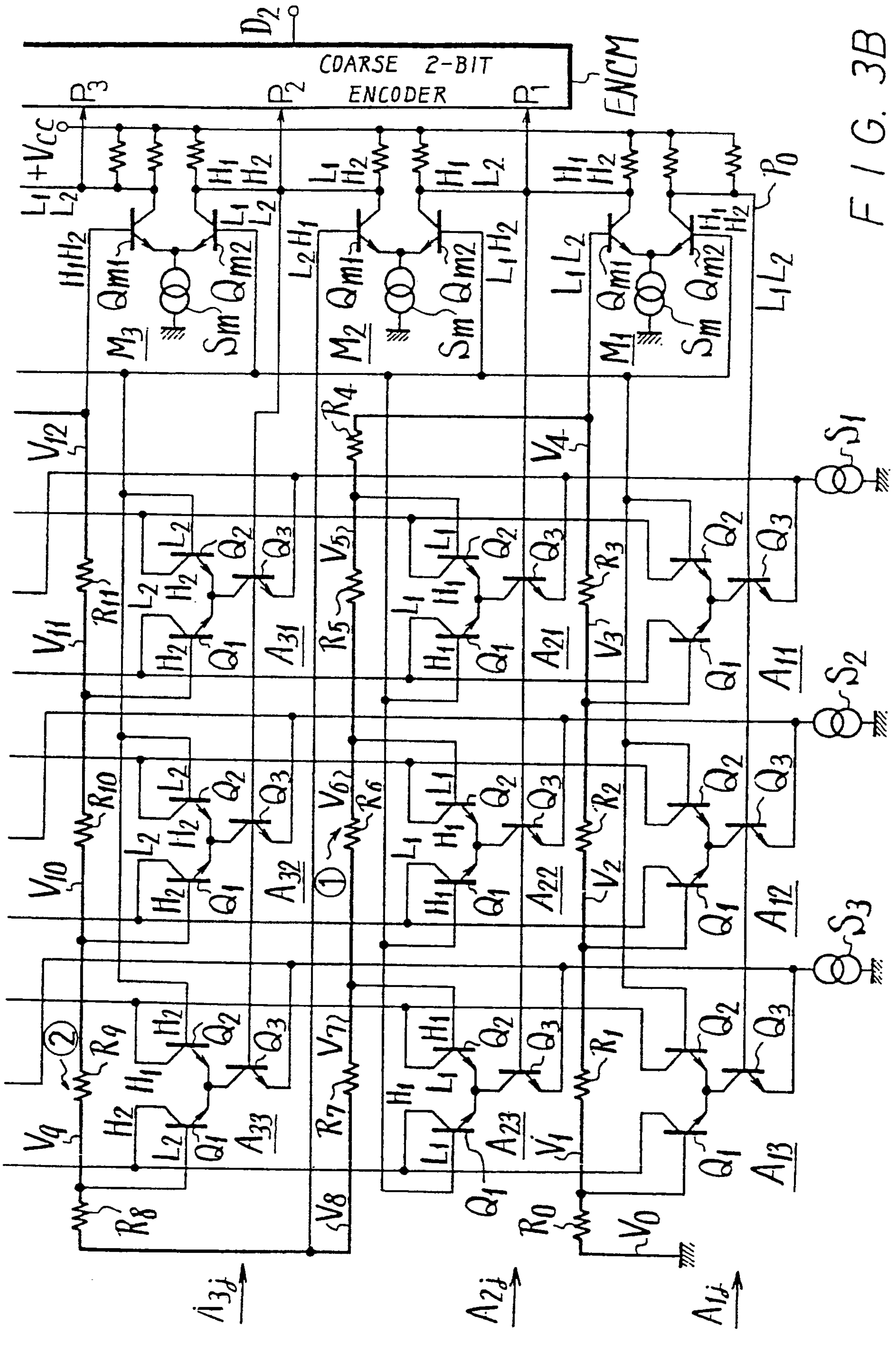
COARSE 2-BIT ENCODER
ENCM
$D_2$
$P_3$
$P_2$
$P_1$
$P_0$
$+V_{CC}$
$M_3$
$M_2$
$M_1$
$Q_{m1}$
$Q_{m2}$
$S_m$
$A_{31}$
$A_{32}$
$A_{33}$
$A_{21}$
$A_{22}$
$A_{23}$
$A_{11}$
$A_{12}$
$A_{13}$
$A_{3j}$
$A_{2j}$
$A_{1j}$
$S_1$
$S_2$
$S_3$
$V_0$
$V_1$
$V_2$
$V_3$
$V_4$
$V_5$
$V_6$
$V_7$
$V_8$
$V_9$
$V_{10}$
$V_{11}$
$V_{12}$
$R_0$
$R_1$
$R_2$
$R_3$
$R_4$
$R_5$
$R_6$
$R_7$
$R_8$
$R_9$
$R_{10}$
$R_{11}$
$Q_1$
$Q_2$
$Q_3$
$H_1$
$H_2$
$L_1$
$L_2$

FIG. 3B

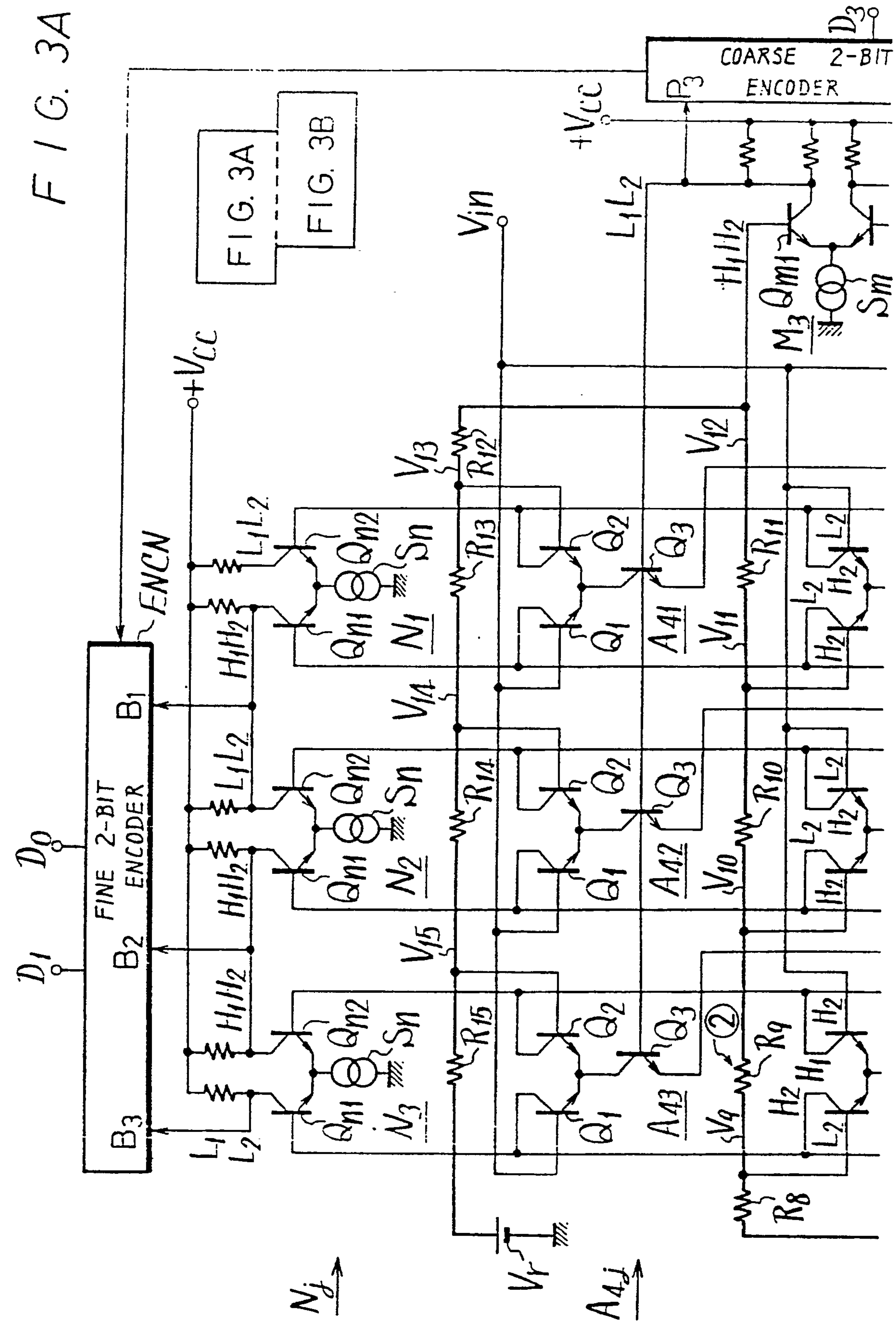
FIG. 3A
FIG. 3B
COARSE 2-BIT ENCODER
FINE 2-BIT ENCODER
ENCN
D0
D1
D3
B1
B2
B3
+Vcc
Vin
Vr
Nj
A4j
N1
N2
N3
A41
A42
A43
Qn1
Qn2
Qm1
Sn
Sm
M3
Q1
Q2
Q3
R8
R9
R10
R11
R12
R13
R14
R15
V9
V10
V11
V12
V13
V14
V15
H1H2
L1L2
H1
H2
L1
L2

FIG. 3A

FIG. 5A

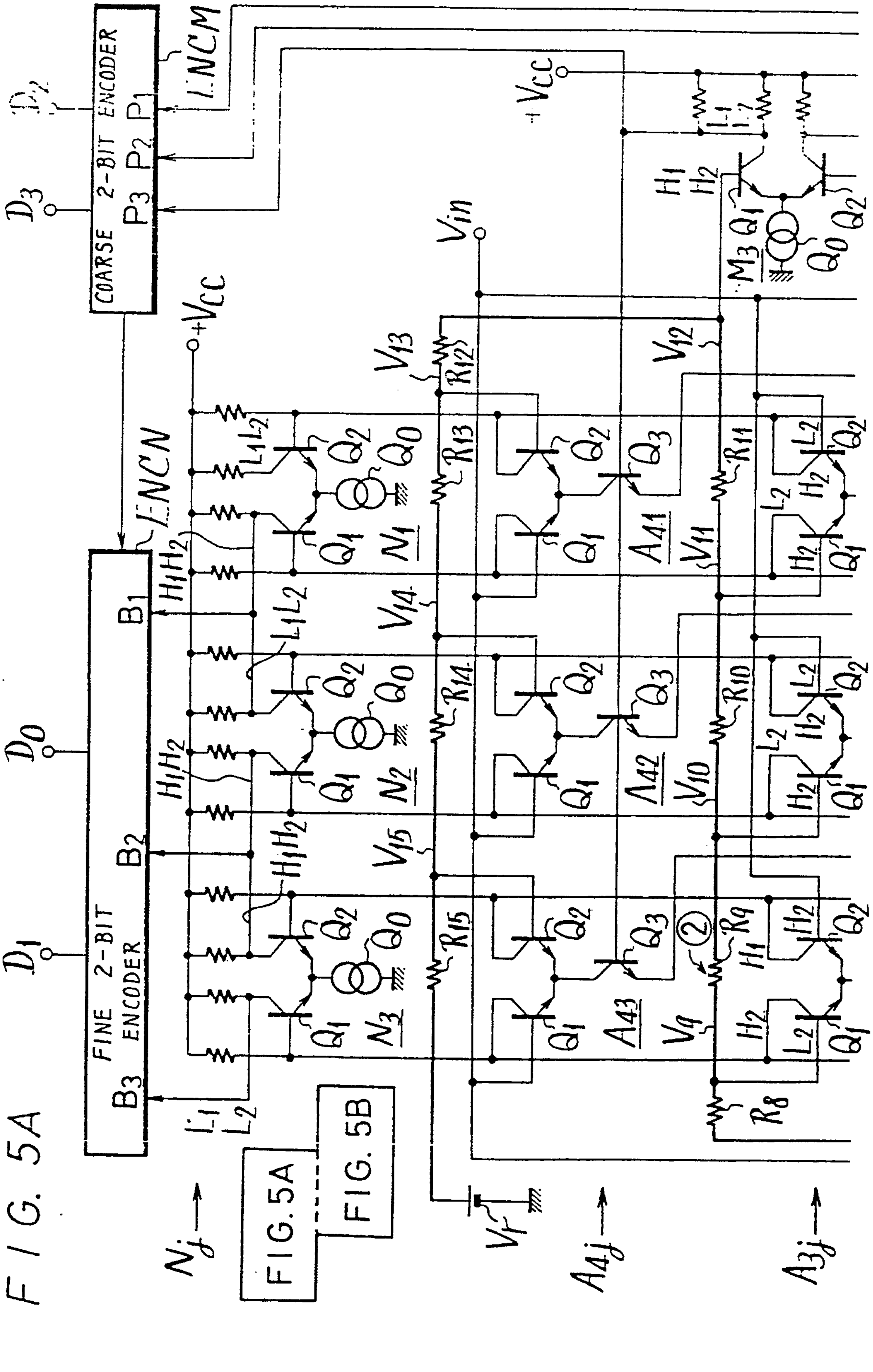
COARSE 2-BIT ENCODER
P3 P2 P1
ENCM
D3
D2
+Vcc
Vin
FINE 2-BIT ENCODER
B1
B2
B3
D0
D1
ENCN
H1H2
L1L2
L1
L2
N1
N2
N3
A41
A42
A43
V9
V10
V11
V12
V13
V14
V15
R8
R9
R10
R11
R12
R13
R14
R15
Q0
Q1
Q2
Q3
M3
Vr
Nj
A4j
A3j
FIG.5A
FIG.5B

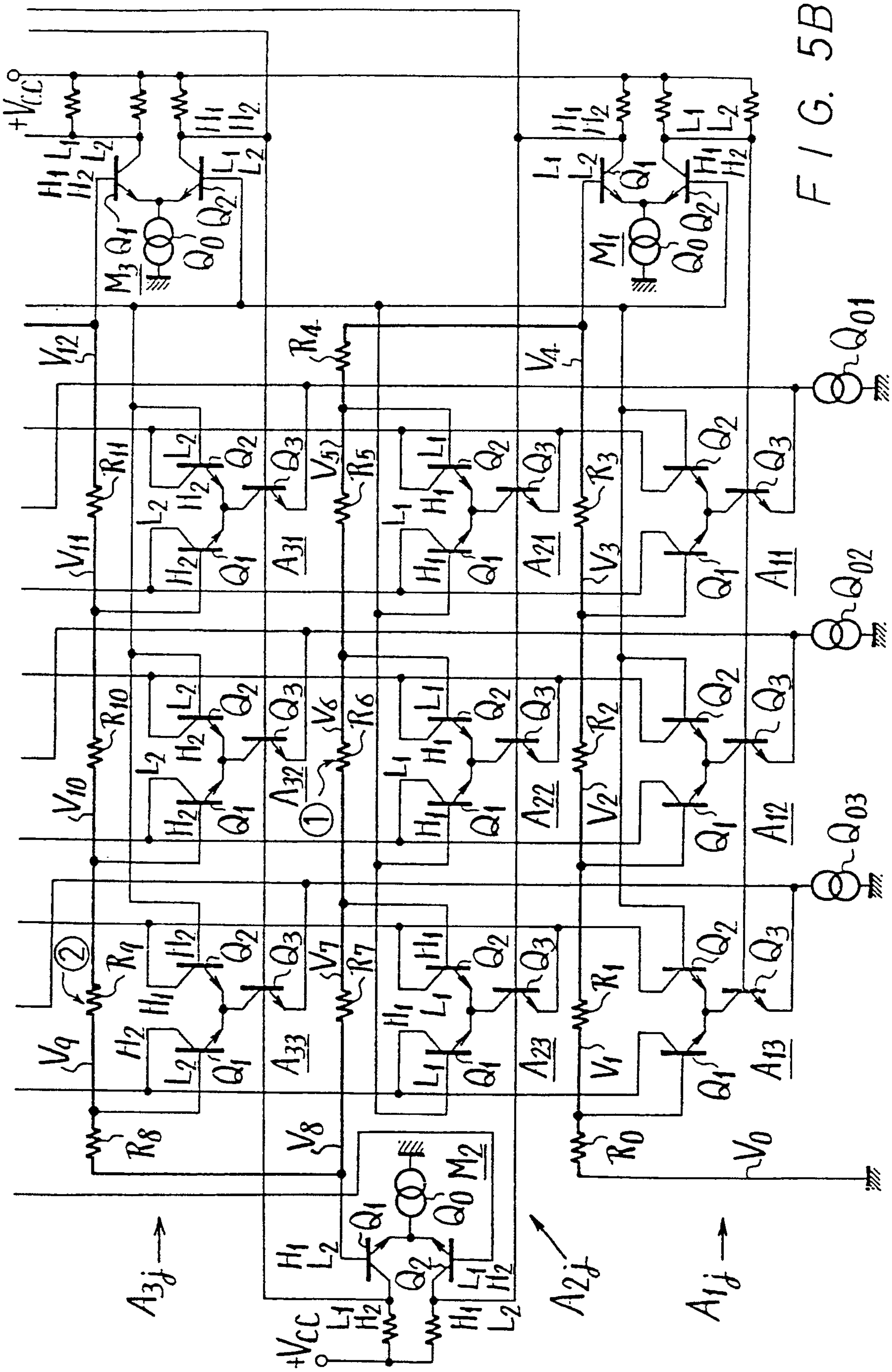
+Vcc
M3
M1
M2
Q01
Q02
Q03
A3j
A2j
A1j
A11
A12
A13
A21
A22
A23
A31
A32
A33
V0
R0

FIG. 5B

FIG. 6A

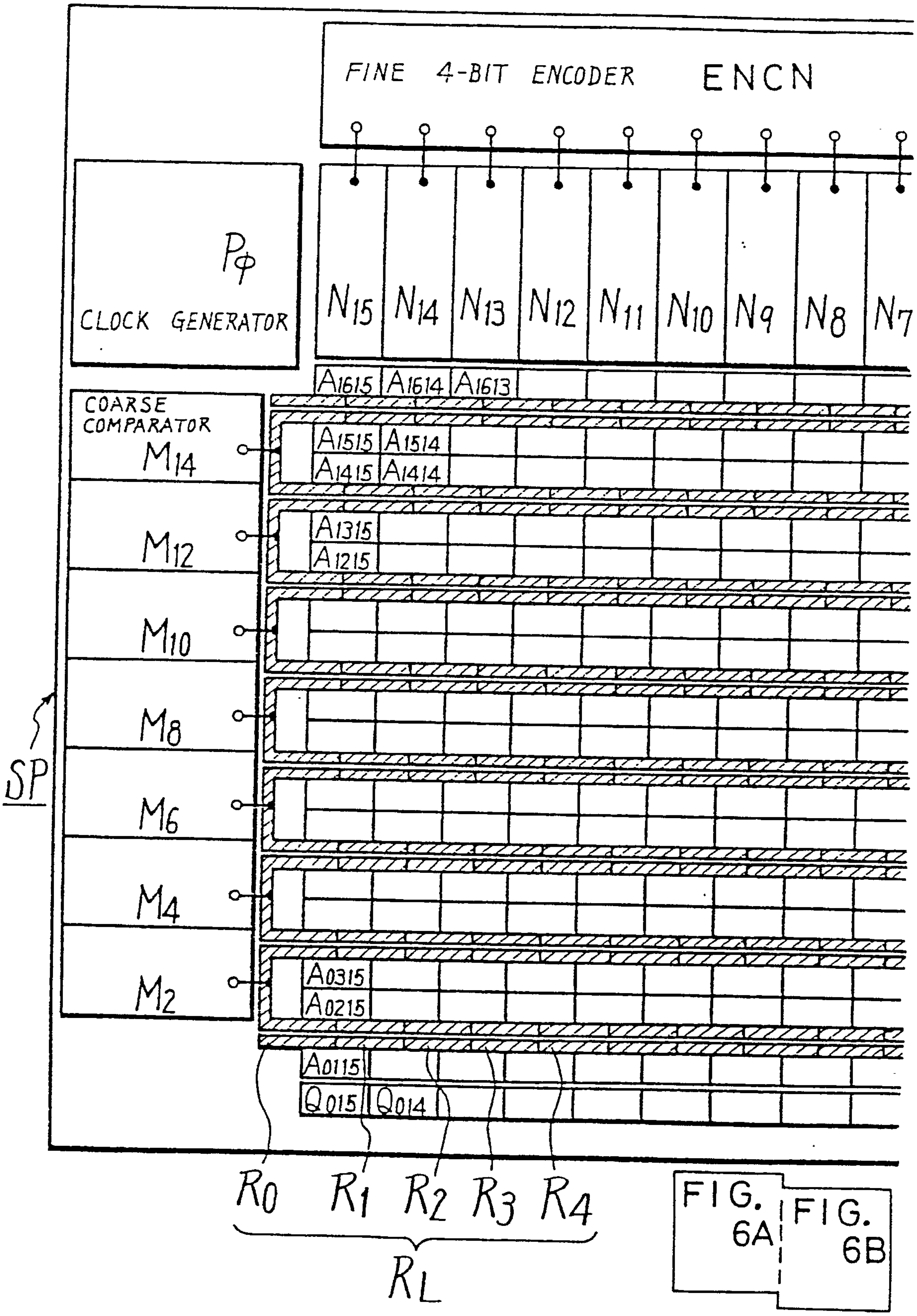
FINE 4-BIT ENCODER ENCN
Pφ
CLOCK GENERATOR
N15
N14
N13
N12
N11
N10
N9
N8
N7
A1615
A1614
A1613
COARSE COMPARATOR
M14
A1515
A1514
A1415
A1414
M12
A1315
A1215
M10
M8
M6
M4
M2
A0315
A0215
A0115
Q015
Q014
SP
R0
R1
R2
R3
R4
RL
FIG. 6A
FIG. 6B

FIG. 6B

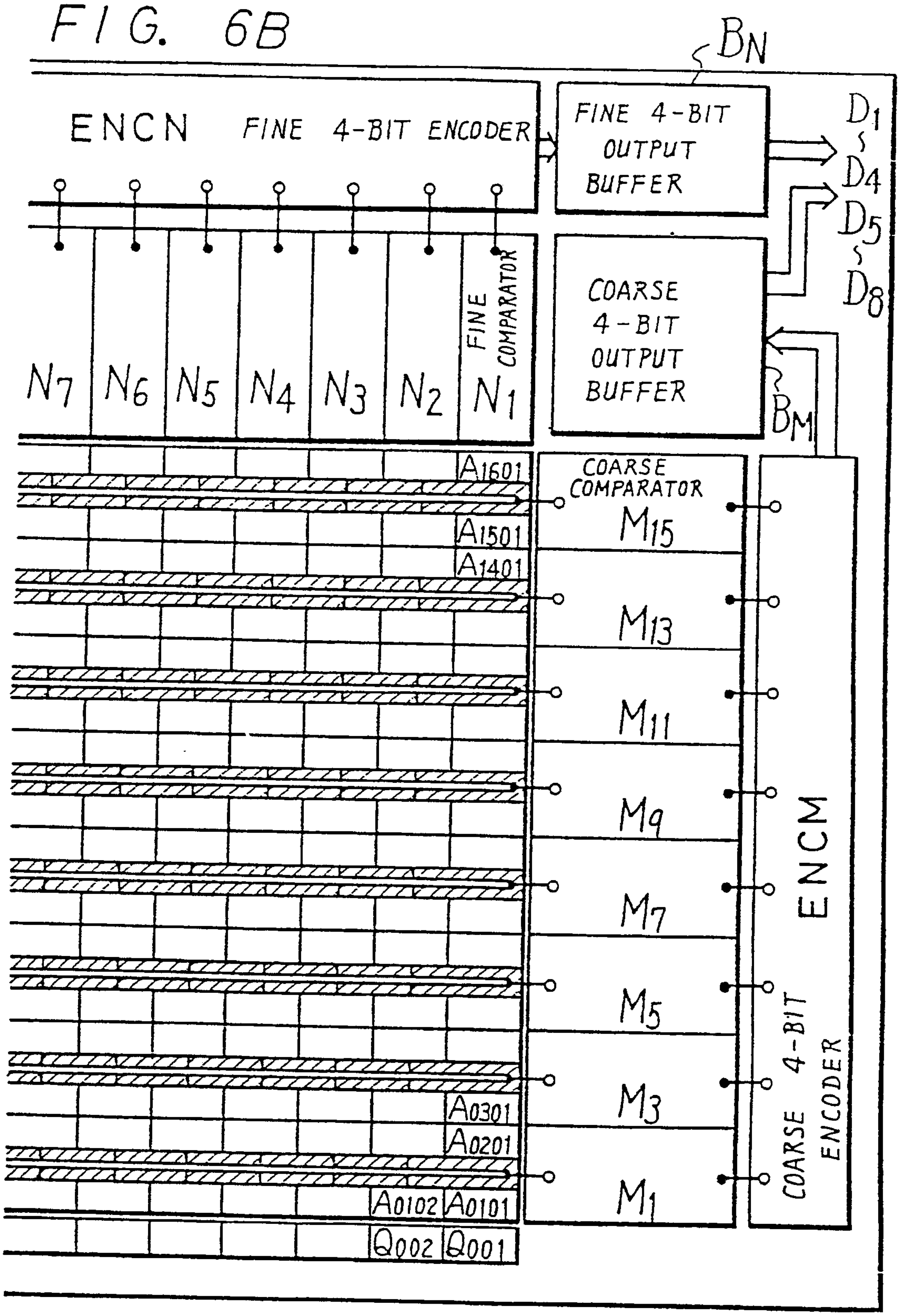

ENCN FINE 4-BIT ENCODER
FINE 4-BIT OUTPUT BUFFER
$B_N$
$D_1$
$D_4$
$D_5$
$D_8$
COARSE 4-BIT OUTPUT BUFFER
$B_M$
FINE COMPARATOR
$N_7$ $N_6$ $N_5$ $N_4$ $N_3$ $N_2$ $N_1$
COARSE COMPARATOR
$A_{1601}$
$A_{1501}$
$A_{1401}$
$A_{0301}$
$A_{0201}$
$A_{0102}$ $A_{0101}$
$Q_{002}$ $Q_{001}$
$M_{15}$
$M_{13}$
$M_{11}$
$M_9$
$M_7$
$M_5$
$M_3$
$M_1$
ENCM
COARSE 4-BIT ENCODER

FIG. 7A

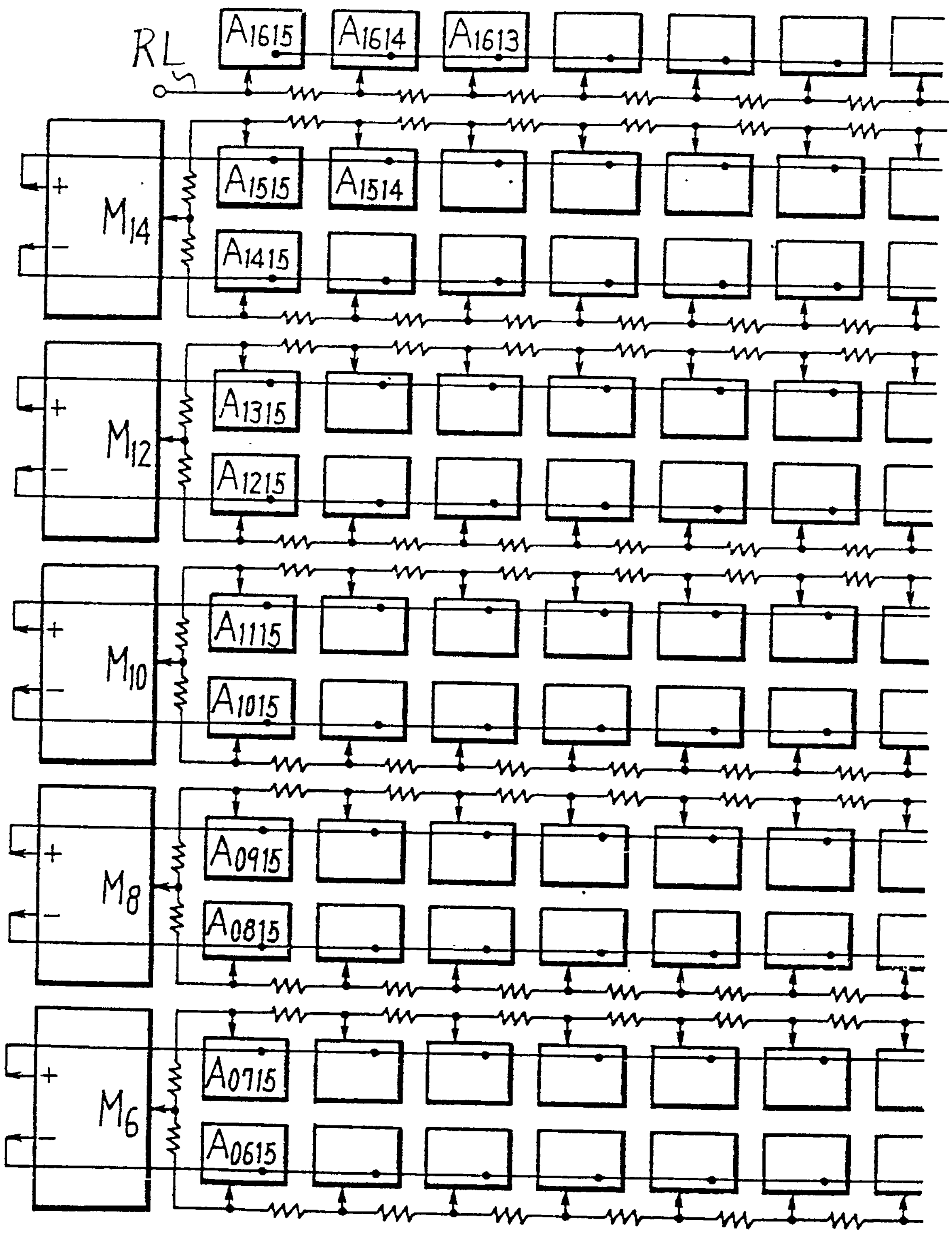
RL
A1615
A1614
A1613
A1515
A1514
A1415
A1315
A1215
A1115
A1015
A0915
A0815
A0715
A0615
M14
M12
M10
M8
M6
+
−

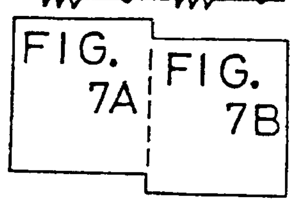
FIG. 7A
FIG. 7B

FIG. 7B

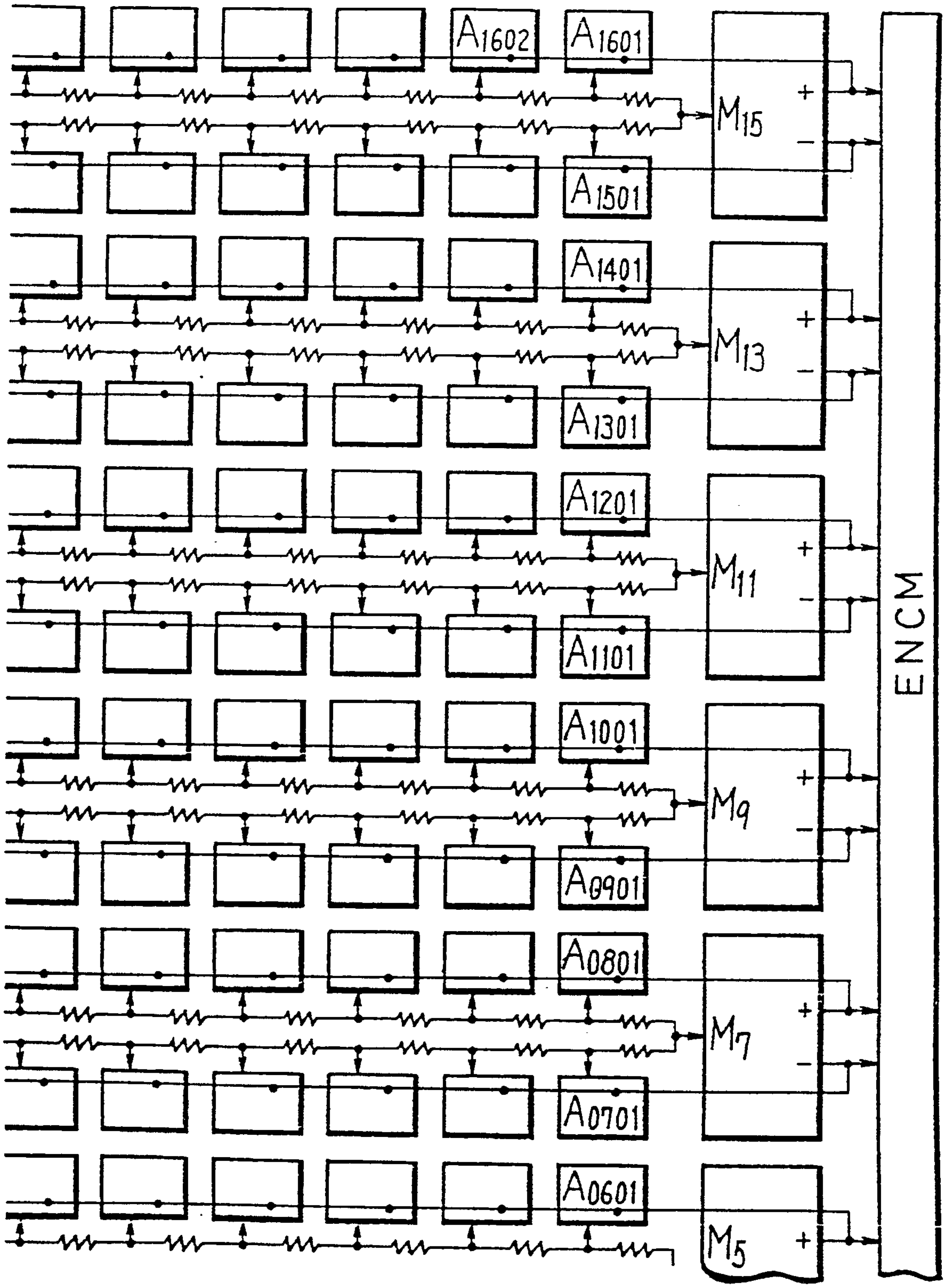
A1602
A1601
A1501
A1401
A1301
A1201
A1101
A1001
A0901
A0801
A0701
A0601
M15
M13
M11
M9
M7
M5
ENCM

FIG. 8A

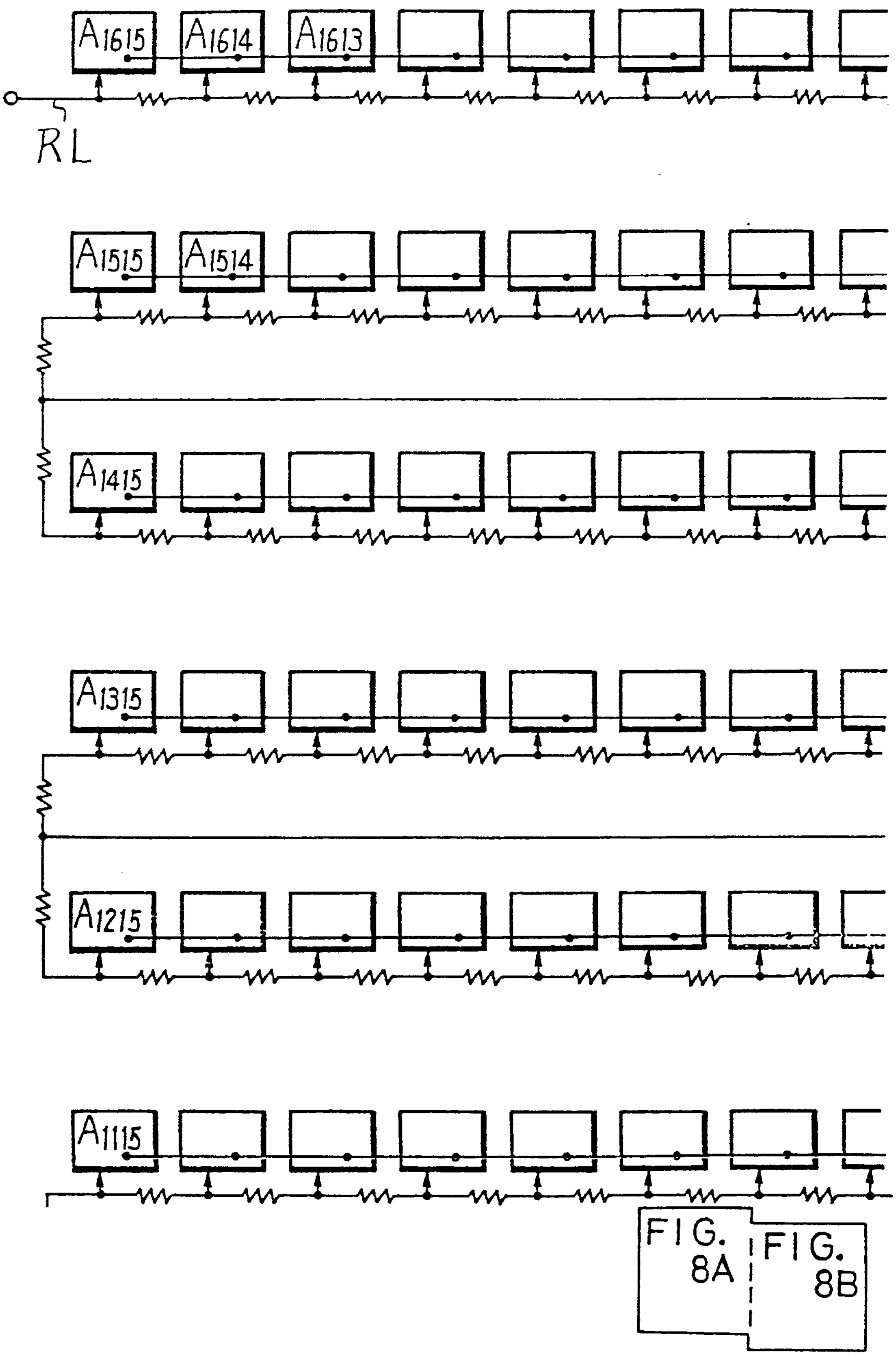
A1615
A1614
A1613
RL
A1515
A1514
A1415
A1315
A1215
A1115
FIG. 8A
FIG. 8B

FIG. 8B

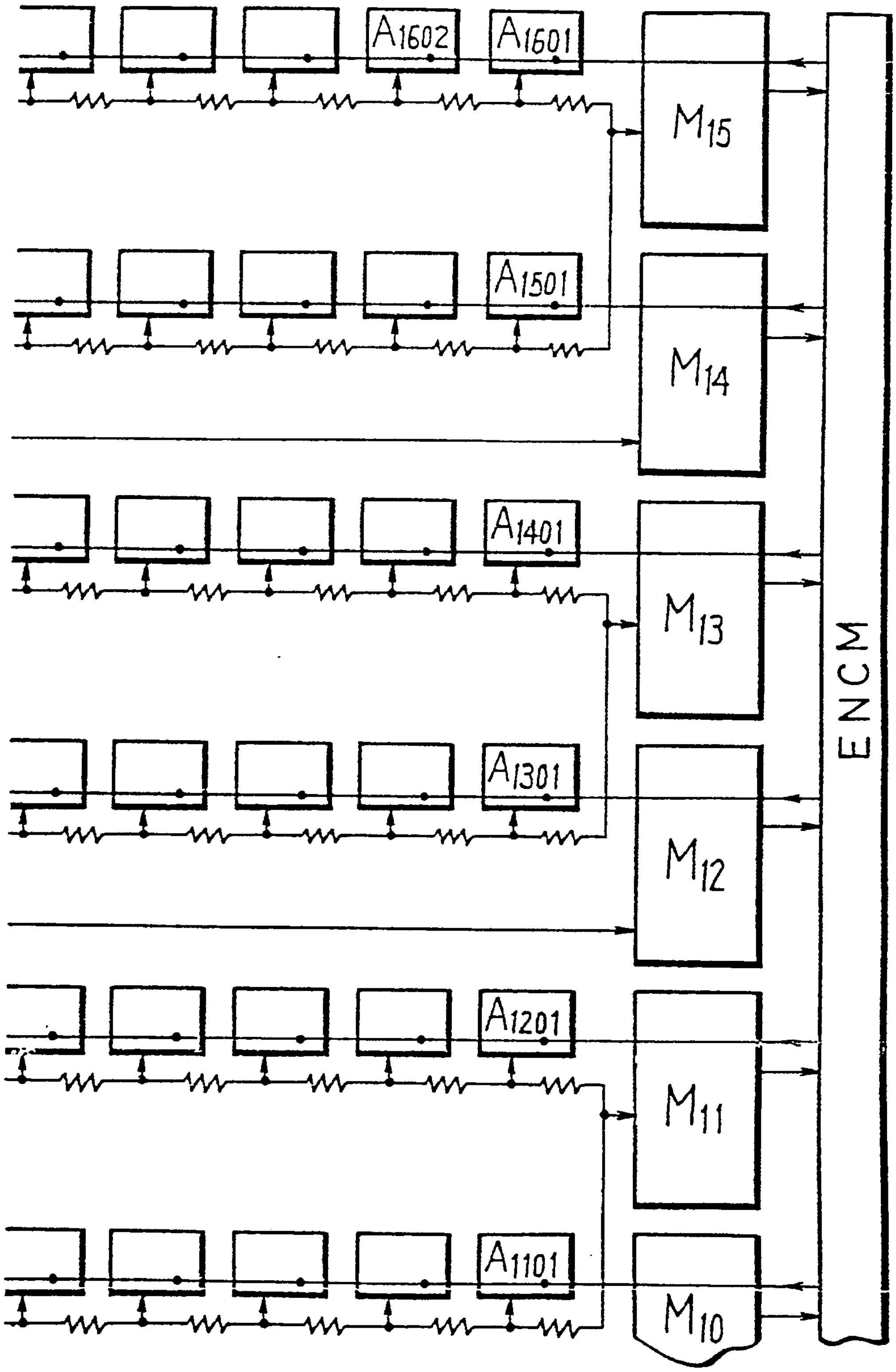
A1602
A1601
M15
A1501
M14
A1401
M13
A1301
M12
A1201
M11
A1101
M10
ENCM

FIG. 9A

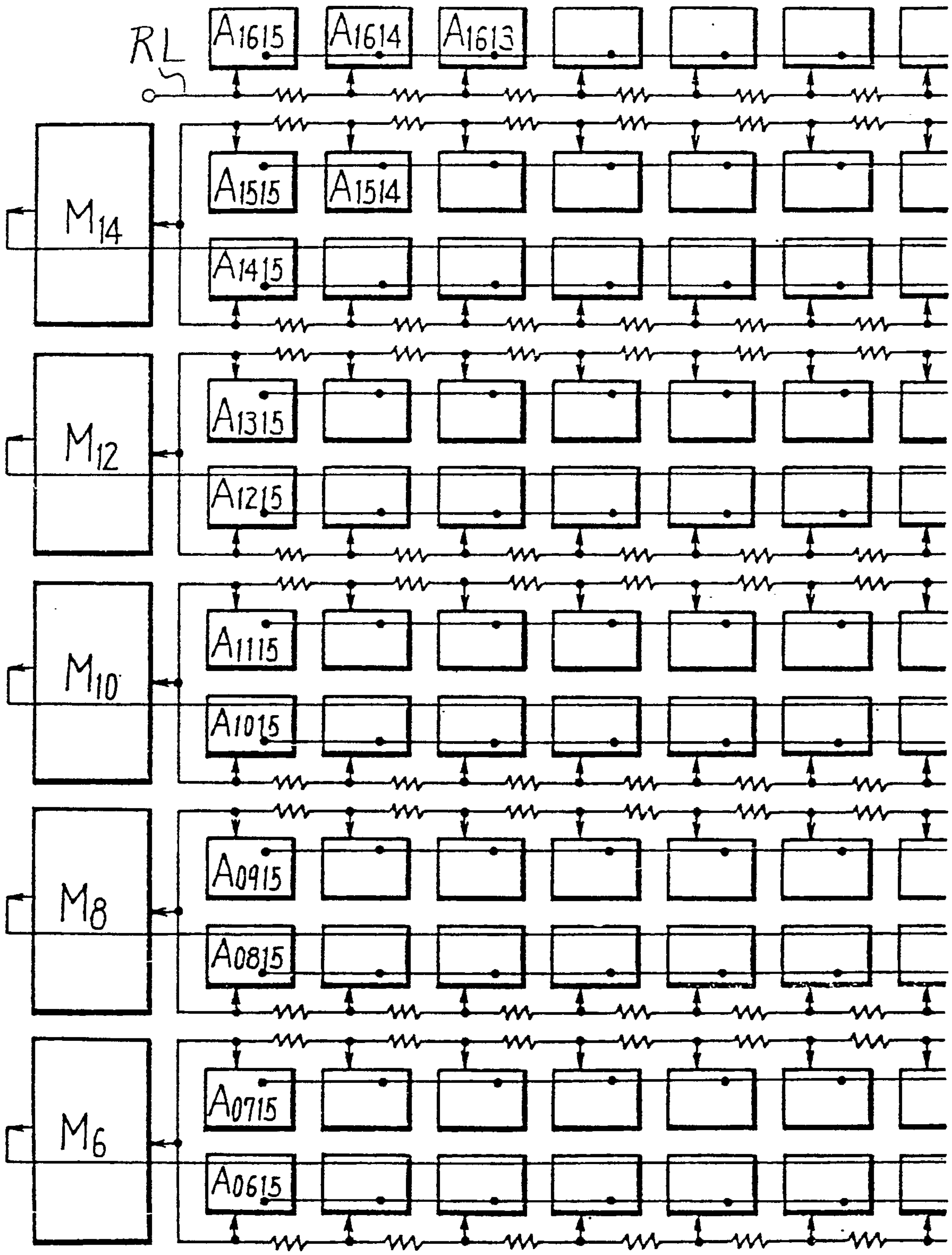
RL
A1615
A1614
A1613
A1515
A1514
A1415
A1315
A1215
A1115
A1015
A0915
A0815
A0715
A0615
M14
M12
M10
M8
M6

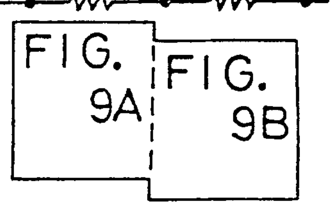
FIG. 9A
FIG. 9B

FIG. 9B

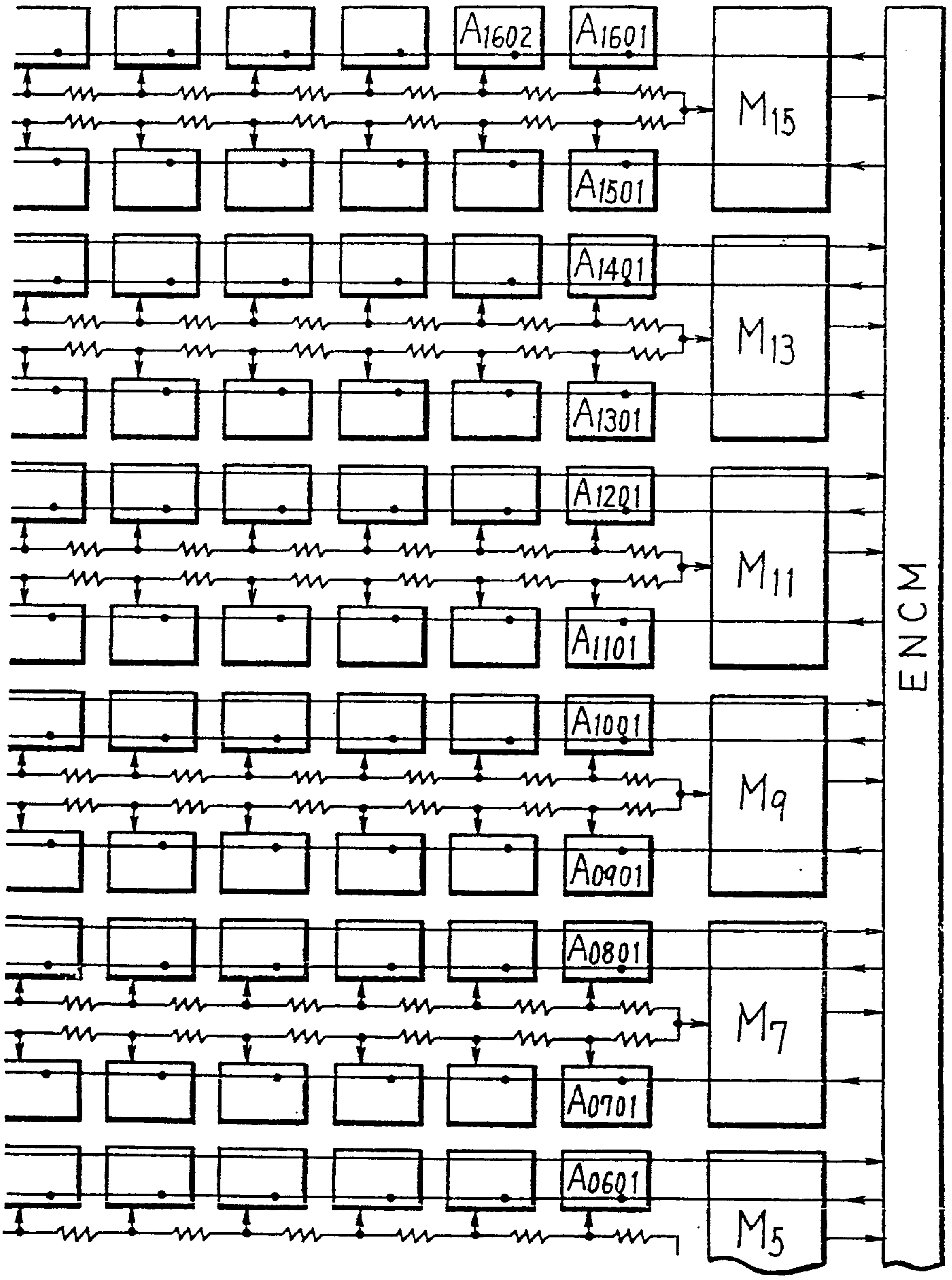
A1602
A1601
M15
A1501
A1401
M13
A1301
A1201
M11
A1101
A1001
M9
A0901
A0801
M7
A0701
A0601
M5
ENCM